# EUROPEAN PATENT APPLICATION

(11) **EP 0 751 573 A1**
(43) Date of publication of application: **02.01.1997**
(21) Application number: 95830279.6
(22) Date of filing: 30.06.1995
(51) Int. Cl.: H01L 27/092, H01L 27/06, H01L 21/761

(54) **Integrated power circuit and corresponding manufacturing process**

(71) Applicant: SGS-THOMSON MICROELECTRONICS S.r.l., 20041 Agrate Brianza (Milano) (IT)
(72) Inventor: Palara, Sergio, I-90526 Acitrezza, (Catania) (IT)
(74) Representative: Bottero, Claudio

(57) **Abstract**

Power circuit integrated on semiconductor material with VIPOWER technology of the type provided on a substrate (1) having a first type of conductivity on which there is a first epitaxial layer (2) of the same type of conductivity.

In this first epitaxial layer (2) is provided an isolation region (43) having a second type of conductivity and in which are provided a first (3) and a second (4) diffused regions and having respectively conductivity of the first and second types.

The power circuit is characterized in that one the first epitaxial layer (2) is grown a second epitaxial layer (8) having conductivity of the first type and in which are partially extended the first (3) and second (4) diffused regions.

## Description

The present invention relates to a power circuit integrated with VIPOWER technology and to a related manufacturing process.

As known, VIPOWER technology exhibits some limitations when it is used in high-frequency applications or when on a substrate of semiconductor material on which the power circuit is integrated there are high-voltage (e.g. >300V/µsec) transistors.

These limitations are due to the presence of high junction capacitances between the semiconductor substrate and diffused and isolated regions having respectively an N or a P type conductivity and comprising a control circuitry for the power device.

The dimensions of these junction capacitors are directly proportionate to the dimensions of the diffused and isolated regions.

It was also noted that when there are abrupt changes in the voltage present on the substrate these junction capacitors transmit disturbances to the control circuitry of the device and compromise its operation.

It would therefore be necessary either to reduce drastically the dimensions of the control circuitry or provide a low resistance capable of conveying to ground a large part of the current injected capacitively from the substrate to the control circuitry.

One known technical solution for solving these shortcomings is set forth in European Patent Applications numbers 95830060.0 and 94830229.4 both of the same applicant.

In the first patent application there is described a process for providing an integrated circuit on a semiconductor substrate comprising a diffused region having a type N conductivity which is isolated from the substrate by means of implantation of a buried region having type P conductivity.

Specifically, the buried region is formed by implantation of high-energy boron.

Normally this buried region exhibits a thickness of approximately 1µm and a distance from the integrated circuit surface dependent upon the implantation energy.

For example, if the implantation energy used is around 900kev the buried region will be at a depth of approximately 1.5µm.

To connect the buried region with the integrated circuit surface there is formed by means of implantation and successive diffusion a deep region having a type P conductivity.

This deep region comprises at least two structurally independent regions which contact laterally the buried region.

The buried region and the deep region form an annular region enclosing the diffused region to isolate it completely from the rest of the integrated device.

While advantageous in some respects this solution exhibits the shortcoming of considerably limiting the thickness of the diffused region.

Generally this thickness is on the order of 1µm depending also on the doping of the region.

But this thickness is insufficient if the diffused region must also include the control circuitry of an integrated power device.

In the second patent application is described a process for providing an integrated power circuit comprising a control circuitry incorporated in a first and in a second diffused region having respectively a type N conductivity and a type P conductivity.

Again in this case the first and second diffused regions are isolated from the rest of the integrated device by means of an annular region comprising a buried region implanted with high energy and a deep region.

When the implantation of the buried region is performed at 900kev the depth at which this region is located does not exceed 2µm.

Considering that the thickness of the buried region is approximately 1µm the residual thickness towards the surface of the integrated circuit is approximately 1µm.

This thickness is insufficient for providing a control circuitry for the power device.

Indeed, the thermal cycles necessary for forming the power portion of the device cause rising of the buried region to the surface.

This shortcoming could be avoided by implantation of the buried region at much higher energy but the entire process would be much costlier.

The technical problem underlying the present invention is to provide an integrated power circuit and a related manufacturing process which would have better voltage tightness for equal manufacturing cost or which for equal voltage tightness would have smaller manufacturing cost.

The solution idea underlying the present invention is to grow on the integrated power circuit surface an epitaxial layer so as to increase the thickness of the type P and type N diffused regions receiving the control circuitry of the power circuit.

The technical problem is solved by a integrated power circuit of the type indicated above and defined in the characterizing part of the annexed claims from 1 to 11.

The technical problem is also solved by a process for embodiment of the above mentioned circuit in accordance with the description set forth in claims 12 to 14.

The characteristics and advantages of the integrated power circuit and related manufacturing process in accordance with the present invention are set forth in the description of an embodiment thereof given below by way of non-limiting example with reference to the annexed drawings.

In the drawings:

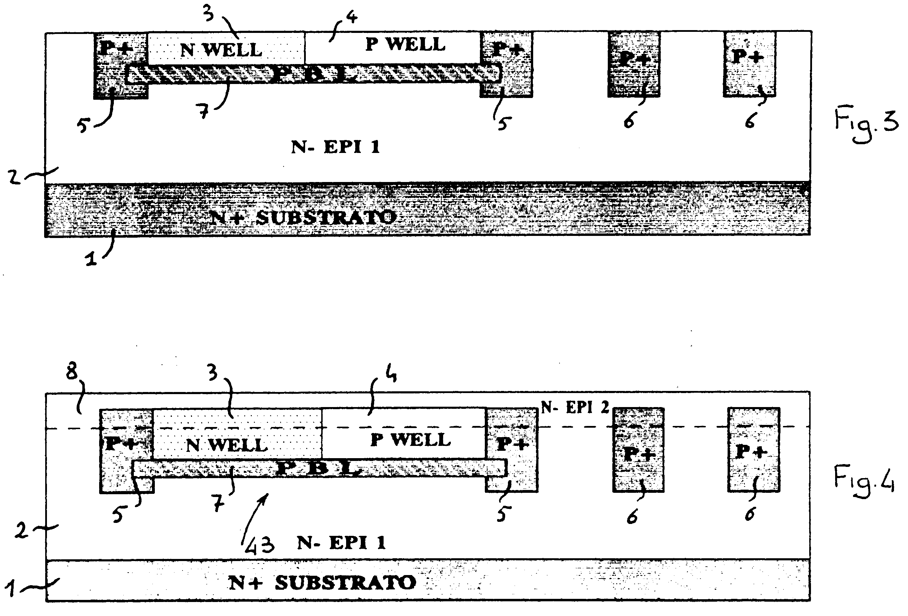

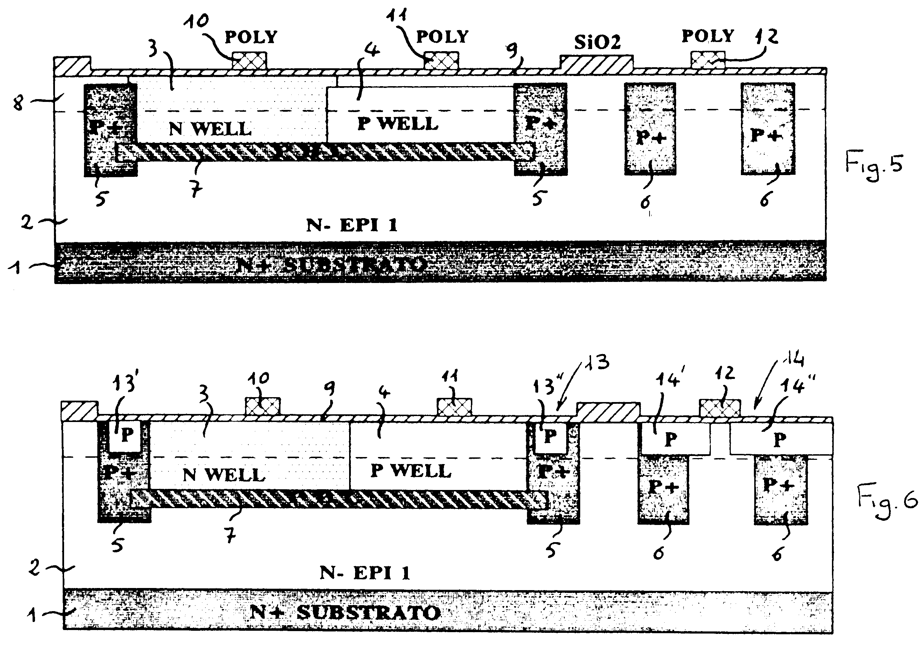

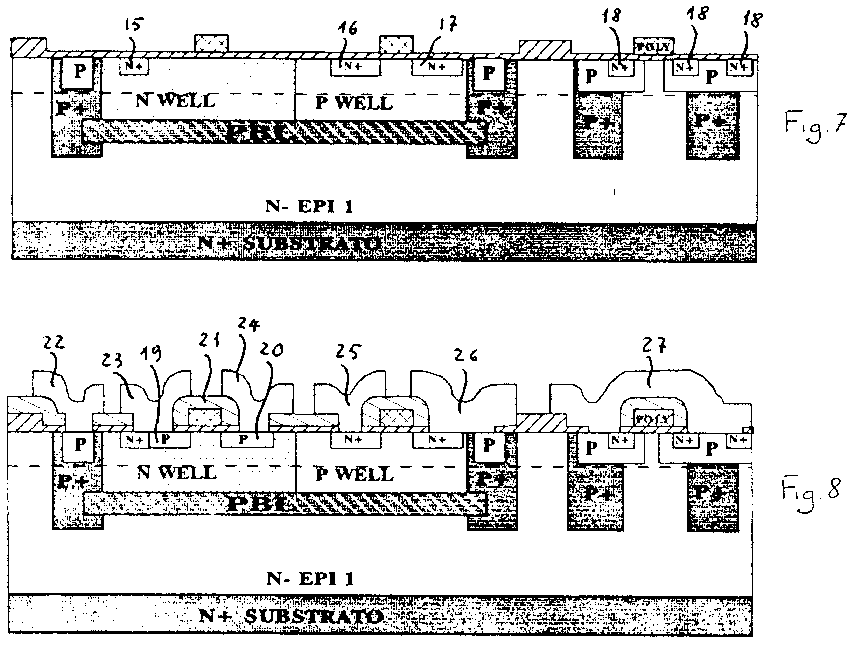

FIGS. 1 to 9 show in enlarged scale and vertical cross section a semiconductor substrate on which are performed in succession the steps of the manufacturing process for the power circuit in accordance with the present invention,
FIG. 10 shows diagrammatically in enlarged scale and vertical cross section an embodiment of the power circuit in accordance with the present invention,
FIG. 11 shows another embodiment of the power circuit in accordance with the present invention, and
FIG. 12 shows another embodiment of the power circuit in accordance with the present invention.

With reference to the FIGS. reference number 40 indicates as a whole and diagrammatically an integrated power circuit provided in accordance with the present invention.

For convenience of explanation the structure of the integrated power circuit in accordance with the present invention is now described with reference to the process steps leading to its embodiment.

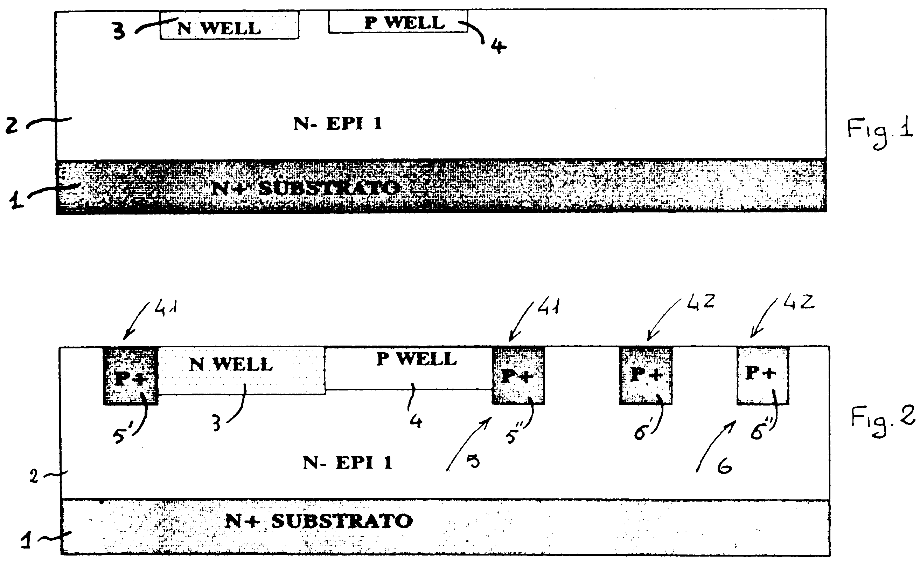

As shown in FIG. 1, to manufacture the power circuit 40 there is used a semiconductor material substrate 1, e.g. silicon, having a first type of conductivity and in particular type N+.

On the substrate 1 is grown a first epitaxial layer 2 having the same type of conductivity and in particular type N-.

Then one proceeds to deposit on the surface of the power circuit 40 a first mask provided by known techniques.

Then, in exposed portions 41 of the first epitaxial layer 2 are formed by means of implantation and successive diffusion heat treatment a first diffused region 3 having a conductivity of the first type and in particular type N and a second diffused region 4 having a conductivity of a second type and in particular type P.

Successively in other exposed portions 41 and 42 of the first epitaxial layer 2 are formed by means of implantation and successive diffusion heat treatment a first 5 and a second 6 deep regions having conductivity of the second type and in particular type P+.

The first deep region 5 and second deep region 6 comprise at least two structurally independent regions 5', 5'', 6', 6'' each.

Simultaneously there is provided another diffusion of the first 3 and second 4 diffused regions.

One then proceeds with deposit of a second mask to form opposite the first 3 and second 4 diffused regions a buried region 7.

This buried region 7 is obtained by means of high-energy implantation, e.g. 900kev, of ions of a dopant having the second type of conductivity, e.g. boron.

The buried region 7 has a depth dependent on the implantation energy, e.g. at 900kev the buried region is at a depth of approximately 1.5µm.

In addition the buried region 7 is limited laterally by the deep region 5 with which it forms the annular isolation region 43 enclosing the first 3 and second 4 diffused regions.

After removal of the second mask one proceeds with growth on the first epitaxial layer 2 of a second epitaxial layer 8 having conductivity of the first type and in particular type N- and thickness of a few µm, e.g. µm.

The diffused regions 3 and 4 and the deep regions 5 and 6, during the successive diffusion heat treatments to which will be subjected the integrated circuit 40 will diffuse partially in the second epitaxial layer 8 increasing their thickness.

One then proceeds to grow on the surface of the integrated circuit 40 a layer of thin oxide 9 by means of known techniques.

Successively there are deposited a first 10, a second 11 and a third 12 polycrystalline silicon layers.

There are then formed by means of implantation and successive diffusion heat treatment a third 13 and a fourth 14 diffused regions having conductivity of the second type and in particular type P.

The third 13 and fourth 14 diffused regions comprise each at least two structurally independent regions 13', 13'', 14', and 14''.

In particular the third diffused region 13 has the purpose of taking to the surface the isolation region 43 to enclose and isolate completely the first 3 and second 4 diffused regions from the rest of the integrated circuit 40.

The fourth diffused region 14 forms so-called 'body' regions of a first power transistor 44 of the vertical current flow type (VDMOS) incorporated in the integrated circuit 40.

One then proceeds with implantation and successive diffusion of a fifth 15, sixth 16, seventh 17 and eighth 18 diffused regions having the first type of conductivity and in particular type N+ and a ninth 19 and tenth 20 diffused regions having the second type of conductivity and in particular type P.

Specifically the fifth 15 and the ninth 19 diffused regions form a source region of a second signal transistor 45 of type MOS with P channel which is provided in the first diffused region 3.

This second transistor 45 also includes a gate region formed by the first polycrystalline silicon layer 10 and a drain region formed by the tenth diffused region 20.

In addition the sixth 16 and seventh 17 diffused regions form respectively a source region and a drain region of a third signal transistor 46 of type MOS with N channel which is provided in the second diffused region 4.

This third transistor 46 also includes a gate region formed by the second polycrystalline silicon layer 11.

The eighth diffused region 18 forms a source region of the first power transistor 44.

This first transistor 44 also includes a drain region formed of the substrate 1 and the first epitaxial layer 2 and a gate region formed by the second layer of polycrystalline silicon 12.

The manufacturing process of the circuit 40 then proceeds in the conventional manner with deposit of a passivating material layer 21.

There are then performed opening of the contacts and deposit of a first 22, second 23, third 24, fourth 25, fifth 26 and sixth 27 metallization.

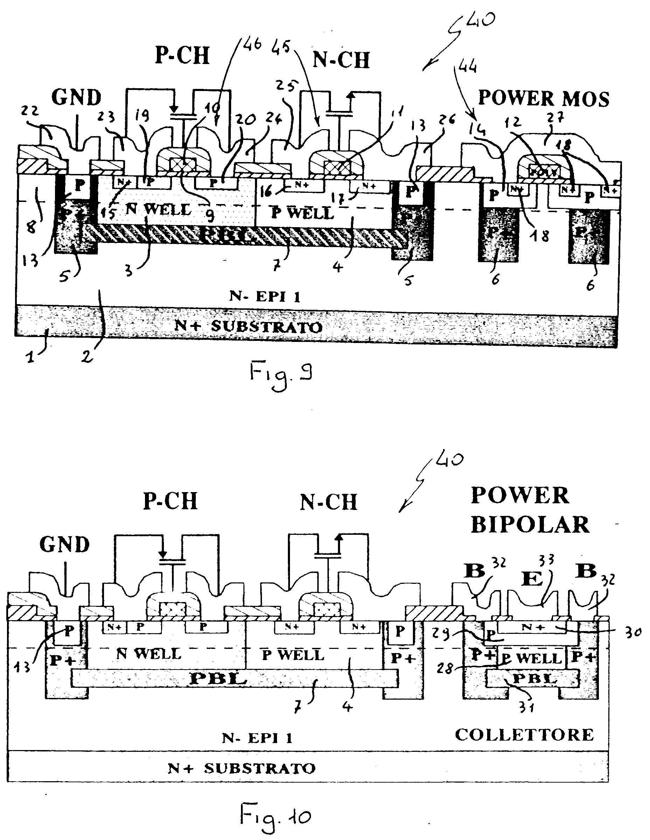

From FIG. 9 it is seen that the first metallization 22 provides a contact with ground GND of the isolation region 43 and the third diffused region 13.

Again in FIG. 9 it is also seen that the source region of the third transistor 45 is connected to ground GND.

Without change to the above mentioned process and replacing the first transistor 44 the integrated circuit 40 comprises a power transistor 47 of bipolar type with vertical current flow.

Specifically as shown in FIG. 10 this transistor 47 comprises a collector region formed of the substrate 1 and the first epitaxial layer 2 and an emitter region 30 which is formed together with the diffused regions 15, 16 and 17.

The transistor 47 also includes a base region incorporating a buried region 31 which is provided with the buried region 7, a diffused region 28 which is formed together with the diffused region 4 and a diffused region 29 which is formed together with the diffused region 13.

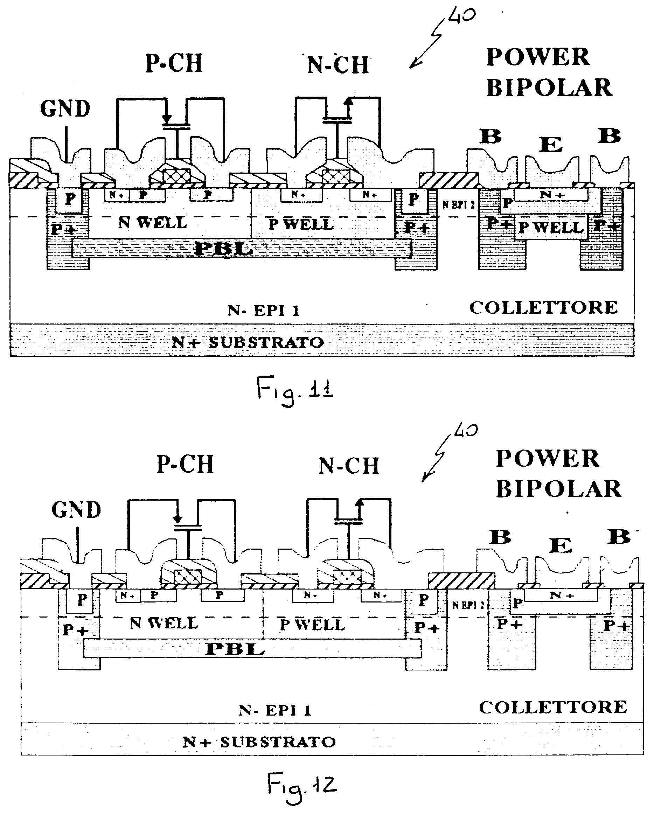

As an alternative as shown in FIG. 11 the transistor 47 can be provided with omission of the buried region 31 or omission either of the buried region 31 or the diffused region 28 as shown in FIG. 12.

In conclusion the introduction in the process of embodiment of the circuit 40 of the second epitaxial layer 8 causes the first 3 and second 4 diffused regions to exhibit a thickness such as to allow greater voltage tightness of the second 45 and the third 46 signal transistors for equal implantation energy of the buried region 7.

In addition for equal voltage tightness of the above mentioned transistors the buried region 7 can be implanted with a lower energy thus reducing process costs.

## Claims

1. Power circuit integrated on a semiconductor material with VIPOWER technology of the type provided on a substrate (1) having a first type of conductivity on which there is a first epitaxial layer (2) of the same type of conductivity with there being provided in said first epitaxial layer (2) an isolation region (43) having a second type of conductivity and inside with are provided a first (3) and a second (4) diffused regions having respectively conductivity of the first and second types and characterized in that on the first epitaxial layer (2) is grown a second epitaxial layer (8) having conductivity of the first type and in which are partially extended the first (3) and second (4) diffused regions.

2. Circuit in accordance with claim 1 and characterized in that the second epitaxial layer (8) covers the isolation region (43).

3. Circuit in accordance with claim 2 and characterized in that in the epitaxial layer (8) is provided a third diffused region (13) having the second type of conductivity extending from the surface of the substrate (1) to the isolation region (43).

4. Circuit in accordance with claim 3 and characterized in that the third diffused region (13) comprises at least two structurally independent regions (13') and (13'').

5. Circuit in accordance with claim 3 and characterized in that the second epitaxial layer (8) has type N conductivity.

6. Circuit in accordance with claim 4 and characterized in that the regions (13') and (13)'' included in the diffused region (13) have type-P conductivity.

7. Circuit in accordance with claim 6 and characterized in that therewith is associated at least one power MOS transistor (44) whose active areas are provided at least partially in said second epitaxial layer (8).

8. Circuit in accordance with claim 6 and characterized in that therewith is associated at least one power transistor (47) of the bipolar type whose active areas are provided at least partially in said second epitaxial layer (8).

9. Power circuit integrated on semiconductor material with VIPOWER technology of the type provided on a substrate (1) having a first type of conductivity on which there is a first epitaxial layer (2) of the same type of conductivity and in said first epitaxial layer (2) there being provided an isolation region (43) having a second type of conductivity in which are provided a first (3) and a second diffused region (4) having respectively conductivity of the first and second types and characterized in that on the first epitaxial layer (2) is grown a second epitaxial layer (8) having conductivity of the first type and in which are partially extended the first (3) and second (4) diffused regions with said circuit also characterized in that therewith is associated at least one power transistor (44) whose active areas are provided at least partially in said second epitaxial layer (8).

10. Circuit in accordance with claim 9 and characterized in that said power transistor (44) is of MOS type.

11. Circuit in accordance with claim 9 and characterized in that said power transistor is a bipolar transistor (47).

12. Manufacturing process for a power circuit integrated on a semiconductor material with VIPOWER technology with said circuit (1) provided on a substrate (1) having a first type of conductivity on which there is a first epitaxial layer (2) of the same type of conductivity and in said first epitaxial layer (2) there being provided an isolation region (43) having a second type of conductivity and in which are provided a first (3) and a second (4) diffused regions having respectively a conductivity of the first and second types and characterized in that it includes the steps of:
- growth on the first epitaxial layer (2) of a second epitaxial layer (8) having the first type of conductivity and in which are successively partially diffused the first (3) and second (4) diffused regions,

13. Process in accordance with claim 12 and characterized in that it includes an additional step of implantation and successive diffusion in said second epitaxial layer (8) of a diffused region (13) having a second type of conductivity to contact the isolation region (43).

14. Process in accordance with claim 13 and characterized in that the second epitaxial layer (8) has a thickness of a few µm.
